(19) Europäisches Patentamt
European Patent Office
Office européen des brevets

(11) **EP 3 840 233 B1**

(12) **FASCICULE DE BREVET EUROPEEN**

(45) Date de publication et mention de la délivrance du brevet:
**27.07.2022 Bulletin 2022/30**

(21) Numéro de dépôt: **20209562.6**

(22) Date de dépôt: **24.11.2020**

(51) Classification Internationale des Brevets (IPC):
***H04B 1/22*** *(2006.01)*

(52) Classification Coopérative des Brevets (CPC):
**H04B 1/22**

(54) **CIRCUIT DE DÉTECTION D'ENVELOPPE ET RÉCEPTEUR INCORPORANT CE CIRCUIT**

SCHALTKREIS ZUR HÜLLKURVENERFASSUNG UND EMPFÄNGER, DER DIESEN SCHALTKREIS ENTHÄLT

CIRCUIT FOR DETECTING AN ENCLOSURE AND RECEIVER INCLUDING SAID CIRCUIT

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **20.12.2019 FR 1915275**

(43) Date de publication de la demande:
**23.06.2021 Bulletin 2021/25**

(73) Titulaire: **Commissariat à l'Energie Atomique et aux Energies Alternatives
75015 Paris (FR)**

(72) Inventeurs:
• **BICAÏS, Simon**
  **38054 GRENOBLE Cedex 09 (FR)**
• **MISCOPEIN, Benoît**
  **38054 GRENOBLE Cedex 09 (FR)**

(74) Mandataire: **INNOV-GROUP**
**310, avenue Berthelot**
**69372 Lyon Cedex 08 (FR)**

(56) Documents cités:
**US-A- 3 508 155**

• **ANTONIO MECOZZI ET AL: "Kramers-Kronig coherent receiver", OPTICA,, vol. 3, no. 11, 20 novembre 2016 (2016-11-20), pages 1220-1227, XP002773963, DOI: 10.1364/OPTICA.3.001220**
• **M.A.M.A. ZAID ET AL: "Envelope detection and correction of SSB", ELECTRONICS LETTERS, vol. 20, no. 22, 1 janvier 1984 (1984-01-01), page 901, XP055723119, GB ISSN: 0013-5194, DOI: 10.1049/el:19840612**
• **Anonymous: "Amplitude modulation - Wikipedia", , 4 décembre 2019 (2019-12-04), XP055723381, Extrait de l'Internet: URL:https://en.wikipedia.org/w/index.php?title=Amplitude_modulation&oldid=929193037 [extrait le 2020-08-18]**

**EP 3 840 233 B1**

## Description

L'invention concerne un circuit et un procédé de détection d'enveloppe ainsi qu'un récepteur incorporant ce circuit de détection d'enveloppe. L'invention concerne également un émetteur spécialement agencé pour travailler avec ce récepteur.

Dans ce texte, l'expression "bande haute-fréquence" désigne une bande continue de fréquences située au-delà de 30 GHz ou au-delà de 90 GHz. Généralement, une telle bande haute-fréquence ne s'étend pas au-delà de 1000 GHz ou au-delà de 1000 THz ou 3000 THz.

La demande croissante en débit de la part des utilisateurs a conduit à l'émergence de nouvelles solutions technologiques dans les réseaux de télécommunication mobile de dernière génération, telles que le MIMO (Multiple Input Multiple Output) massif, la densification cellulaire au moyen de petites cellules, l'accès multi-RAT (Radio Access Technology) exploitant conjointement une bande inférieure à 6 GHz et la bande millimétrique. Plus récemment il a été proposé d'utiliser des bandes hautes-fréquences entre 100 et 300 GHz, dites sub-THz, pour des communications à très haut débit. Ces communications sub-THz sont envisagées par exemple pour les liaisons point à multipoint où une station de base transmet des données à très haut débit et faible distance à une pluralité de terminaux mobiles sur la voie descendante. Elles sont aussi envisagées pour établir des liaisons point-à-point entre stations de base dans un réseau de Backhaul, ou encore des liaisons de très courtes portées.

L'exploitation des bandes hautes-fréquences suppose toutefois de résoudre des problèmes de consommation énergétique et de stabilité des oscillateurs hautes-fréquences. La difficulté à réaliser des oscillateurs hautes-fréquences stables dans cette gamme de fréquences fait que les systèmes de communication sub-THz sont très sensibles au bruit de phase. Le bruit de phase affecte aussi bien l'oscillateur haute fréquence de l'émetteur que celui du récepteur. À ce bruit de phase s'ajoute le problème classique de décalage entre la fréquence de l'oscillateur du récepteur et celle de l'oscillateur de l'émetteur ou CFO (Carrier Frequency Offset). Le taux d'erreur symbole peut alors devenir très élevé.

Différentes stratégies ont été proposées dans l'état de la technique pour minimiser l'impact du bruit de phase des oscillateurs haute-fréquences sur les performances de communications. À ce titre, nous pouvons citer l'optimisation de la modulation et de la démodulation pour les canaux avec bruit de phase. Cependant, cette stratégie mène à des algorithmes et des architectures radiofréquences complexes, ce qui ne répond pas toujours aux conditions requises par les applications sub-THz envisagées. De plus les taux d'erreur symbole dans ce cas sont limités par un plancher d'erreur, possiblement élevé.

Une alternative est de considérer l'emploi d'un récepteur utilisant la détection d'enveloppe et ainsi éviter l'utilisation d'un oscillateur haute-fréquence dans le récepteur ainsi que l'impact négatif de son bruit de phase. Cependant, à ce jour, la détection d'enveloppe ne permet qu'une démodulation non-cohérente. Ceci est problématique pour atteindre les débits élevés envisagés pour les applications sub-THz, l'efficacité spectrale des communications non-cohérentes étant limitée.

Enfin, il convient de mentionner l'article de H. Voelcker intitulé « Demodulation of single-sideband signais via envelope détection », IEEE Transactions on Communications Technology, vol. 14, n° 1, Février 1966. Cet article correspond au brevet US3508155. Cet article démontre que l'insertion d'une porteuse pure dans le spectre permet de démoduler de manière cohérente le signal d'intérêt à partir d'une détection enveloppe. On parle d'auto mélange. Toutefois, cette dernière stratégie n'est pas optimale dans la mesure où elle requiert la transmission d'une porteuse pure de puissance élevée comparé au signal utile et entraîne ainsi une importante augmentation de la puissance d'émission. De plus, le récepteur décrit dans l'article de H. Voelcker nécessite la réalisation d'opérations complexes sur le signal reçu comme une transformée de Hilbert. Ceci rend ce récepteur difficile à mettre en œuvre.

De l'état de la technique est également connu des articles suivants :

- Antonio MECOZZI et Al : "Kramers-Kronig coherent receiver", OPTICA, vol. 3, N°11, 20/11/2016, pages 1220-1227,
- M.A.M.A Zaid et Al : "Eveloppe détection and correction of SSB", Electronics letters, vol. 20, n°22, 1/01/1984, page 901.

L'invention vise à proposer une nouvelle architecture radiofréquence de transmission qui résout au moins l'un des inconvénients précités.

Elle a donc pour objet un circuit de détection d'enveloppe conforme à la revendication 1.

L'invention a également pour objet un récepteur pour recevoir un signal modulé comportant une enveloppe modulée par une porteuse à une fréquence $f_c$ prédéterminée comprise dans la bande haute-fréquence, ce récepteur étant conforme à la revendication 3.

L'invention a également pour objet un procédé de détection d'enveloppe pour un signal modulé dans une bande haute-fréquence, ce procédé étant conforme à la revendication 6.

L'invention sera mieux comprise à la lecture de la description qui va suivre, donnée uniquement à titre d'exemple non limitatif et faite en se référant aux dessins sur lesquels :

- la figure 1 est une illustration schématique de l'architecture d'un émetteur d'un signal modulé dans une bande haute-fréquence ;
- la figure 2 est une illustration schématique de l'architecture d'un récepteur d'un signal émis par l'émetteur de la figure 1;
- la figure 3 est une illustration schématique de l'architecture d'un circuit de détection d'enveloppe mis en œuvre dans le récepteur de la figure 2;
- la figure 4 est un organigramme d'un procédé d'émission et de réception d'un signal modulé dans une bande haute-fréquence l'aide de l'émetteur de la figure 1 et du récepteur de la figure 2;
- la figure 5 est un organigramme d'un procédé de détection d'enveloppe à l'aide du circuit de la figure 3.

Dans ces figures, les mêmes références sont utilisées pour désigner les mêmes éléments. Dans la suite de cette description, les caractéristiques et fonctions bien connues de l'homme du métier ne sont pas décrites en détail.

Chapitre I : Exemples de mode de réalisation :

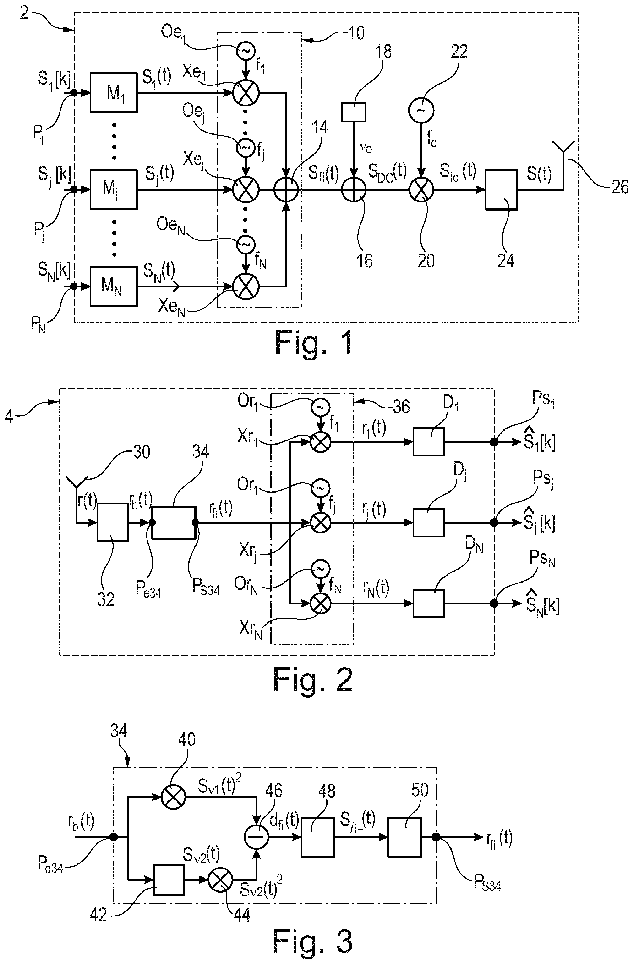

Dans ce chapitre, une description analytique et détaillée d'un mode de réalisation de la chaîne de transmission radiofréquence est donnée en référence aux figures 1 à 5. Ce mode de réalisation est décrit dans le cas particulier d'un système de communication avec N sous-porteuses, où N est un nombre entier supérieur à deux. En effet, la parallélisation des sous-porteuses permet d'atteindre des débits de symboles numériques très important tout en utilisant des convertisseurs analogique-numérique lents. Par exemple, N est supérieur à $2^2$ ou $2^3$ ou $2^4$. De plus, généralement, N est inférieur à $2^{20}$. Par la suite, l'indice j est utilisé pour identifier une sous-porteuse. Cet indice j est donc compris entre 1 et N.

Chacune de ces sous-porteuses forme un canal de transmission d'informations indépendant des autres canaux. Ainsi, les informations transmises sur un de ces canaux peuvent être totalement indépendantes des informations transmises en parallèle sur les autres canaux. Par la suite, l'indice j est aussi utilisé pour identifier un canal particulier parmi l'ensemble des canaux disponibles.

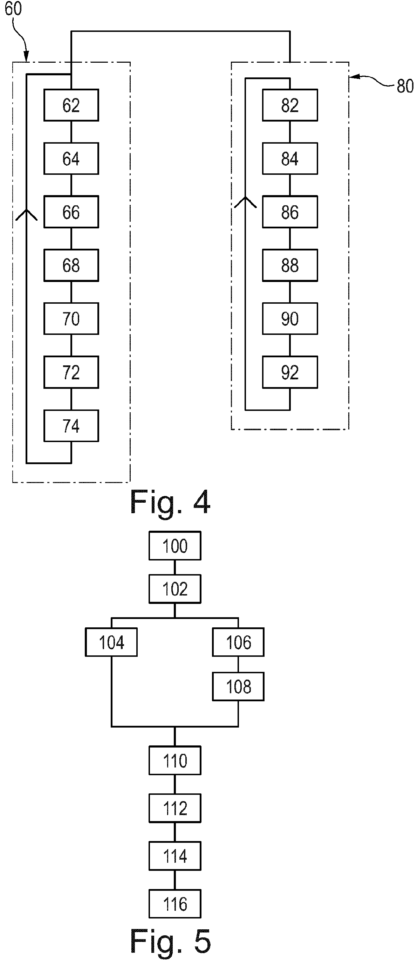

Par la suite, les architectures matérielles d'un émetteur 2 et d'un récepteur 4 utilisés pour mettre en œuvre le procédé de transmission de la figure 4 sont brièvement introduites. Les détails sur le fonctionnement de chacun des éléments de ces architectures matérielles sont ensuite données en référence aux figures 4 et 5.

L'émetteur 2 comporte N ports d'entrée $P_1$ à $P_N$. Chaque port $P_j$ est raccordé à une source respective de symboles numériques non représentée sur les figures. Dans la figure 1, comme dans les autres figures, le symbole "..." indique que certains éléments n'ont pas été représentés pour simplifier l'illustration. Toutefois, les éléments non représentés se déduisent sans difficulté des explications données dans ce texte.

Chaque port $P_j$ est raccordé à une entrée d'un modulateur $M_j$. Le modulateur $M_j$ module chaque symbole $S_j[k]$ reçu sur son entrée pour générer en sortie un signal analogique modulé $S_j(t)$ correspondant.

Les sorties des modulateurs $M_j$ sont raccordées à des entrées respectives d'un circuit 10 de répartition des N signaux $S_j(t)$ sur N sous-porteuses distinctes. Le circuit 10 génère en sortie un signal $s_{fi}(t)$ dans une bande intermédiaire de fréquence et dans lequel chaque signal $S_j(t)$ module une sous-porteuse respective. Pour cela, le circuit 10 comporte, pour chaque signal $s_j(t)$, un multiplieur $Xe_j$ dont une entrée reçoit le signal $S_j(t)$ et une entrée est raccordée à la sortie d'un oscillateur respectif $Oe_j$. L'oscillateur $Oe_j$ génère sur sa sortie une porteuse à la fréquence $f_j$. Le multiplieur $Xe_j$ multiplie les signaux reçus sur ses entrées et délivre le résultat de cette multiplication sur sa sortie.

Le circuit 10 comporte aussi un additionneur 14 qui comporte N entrées raccordées chacune à une sortie d'un multiplieur $Xe_j$ respectif. L'additionneur 14 additionne les sorties de chacun des multiplieurs $Xe_j$ et délivre en sortie le signal $s_{fi}(t)$.

La sortie du circuit 10 est raccordée à une entrée d'un additionneur 16. Une autre entrée de l'additionneur 16 est raccordée à une sortie d'un générateur 18 de tension continue. Le générateur 18 délivre une tension continue d'amplitude constante $v_0$. L'additionneur 16 génère en sortie un signal $s_{DC}(t)$.

La sortie de l'additionneur 16 est raccordée à une entrée d'un multiplieur 20. Une autre entrée du multiplieur 20 est raccordée à une sortie d'un oscillateur haute-fréquence 22. L'oscillateur 22 génère sur sa sortie une porteuse à la fréquence $f_c$. Le multiplieur délivre sur sa sortie un signal $s_{fc}(t)$ qui est le résultat de la multiplication l'un par l'autre des signaux reçus sur ses entrées.

La sortie du multiplieur 20 est raccordée à une entrée d'un filtre 24. En sortie, le filtre 24 délivre le signal filtré s(t).

Le signal s(t) est émis vers le récepteur 4 par l'intermédiaire d'un point 26 de sortie. Ici, le point 26 de sortie est une antenne qui rayonne dans l'air le signal s(t) en direction du récepteur 4.

Le récepteur 4 (Figure 2) comporte point 30 d'entrée qui reçoit le signal rayonné par l'émetteur 2. Ici, ce point 30 est une antenne. Le point 30 délivre un signal électrique reçu r(t) sur une entrée d'un filtre 32.

Le filtre 32 délivre sur sa sortie un signal filtré rb(t).

La sortie du filtre 32 est raccordée à un port $P_{e34}$ d'entrée d'un circuit 34 de détection d'enveloppe. Le circuit 34 génère sur un port $P_{s34}$ de sortie un signal $r_{fi}(t)$. Le circuit 34 est utilisé pour la translation en fréquence de la bande haute-fréquence à la bande intermédiaire. Cette fonction est habituellement réalisée par un oscillateur haute-fréquence associé à un mélangeur. Néanmoins, comme précédemment indiqué, les oscillateurs haute-fréquence présentent des performances médiocres et induisent de forts bruit de phase dont l'impact sur les performances de communication est désastreux. Le circuit 34 réalise cette translation en fréquence tout en atténuant l'impact du bruit de phase.

Le port $P_{s34}$ est raccordé à l'entrée d'un circuit 36 d'isolation de sous-porteuses. Le circuit 36 réalise l'opération inverse de celle réalisée par le circuit 10. Pour cela, le circuit 36 comporte N multiplieurs $Xr_j$. Chaque multiplieur $Xr_j$ comporte une entrée raccordée au port $P_{s34}$ du circuit 34 est une autre entrée raccordée à un oscillateur respectif $Or_j$. L'oscillateur $Or_j$ génère sur sa sortie une porteuse à la fréquence $f_j$. Chaque multiplieur $Xr_j$ délivre sur sa sortie un signal $r_j(t)$ qui est le résultat de la multiplication des signaux reçus sur ses entrées.

La sortie de chaque multiplieur $Xr_j$ est raccordée à l'entrée d'un démodulateur respectif $D_j$. Le démodulateur $D_j$ construit, à partir du signal $r_j(t)$, une estimation $\hat{s}_j[k]$ du symbole $S_j[k]$ émis par l'émetteur à l'instant k sur la canal j. Le démodulateur $D_j$ réalise donc l'opération inverse de celle réalisée par le modulateur $M_j$.

La figure 3 représente plus en détail un exemple d'architecture matérielle du circuit 34 de détection d'enveloppe. Le port $P_{e34}$ d'entrée du circuit 34 est raccordé d'un coté à une entrée d'un multiplieur 40 et de l'autre coté à une entrée d'un modificateur 42. Ainsi, le multiplieur 40 et le modificateur 42 reçoivent tous les deux un exemplaire ou une copie du même signal $r_b(t)$.

Le multiplieur 40 multiplie le signal reçu sur son entrée par lui-même et délivre sur sa sortie le résultat de cette multiplication, c'est-à-dire ici un signal $s_{v1}(t)^2$. Par exemple, le multiplieur 40 est un auto-mélangeur de fréquences.

Dans ce mode de réalisation, le modificateur 42 est un filtre qui filtre le signal rb(t) et délivre sur sa sortie le signal modifié $s_{v2}(t)$.

La sortie du modificateur 42 est raccordée à l'entré d'un multiplieur 44. Le multiplieur 44 multiplie par lui-même le signal $s_{v2}(t)$ pour obtenir un signal $s_{v2}(t)^2$. Le signal $s_{v2}(t)^2$ est délivré sur la sortie du multiplieur 44.

Les sorties des multiplieurs 40 et 44 sont raccordées aux entrées respectives d'un soustracteur 46. Le soustracteur 46 soustrait les signaux reçus sur ses entrées pour obtenir un signal de différence $d_{fi}(t)$. Le signal dfi(t) est délivré sur la sortie du soustracteur 46.

La sortie du soustracteur 46 est raccordée à l'entrée d'un diviseur 48. Le diviseur 48 divise l'amplitude du signal reçu sur son entrée par une constante pour obtenir un signal $s_{fi}+(t)$. Le résultat de cette division est délivré sur une sortie du diviseur 48.

La sortie du diviseur 48 est raccordée à une entrée d'un filtre 50. Le filtre 50 génère le signal $r_{fi}(t)$ sur le port $P_{s34}$ de sortie du circuit 34.

Le procédé de la figure 4 se décompose en deux grandes phases parallèles, à savoir une phase 60 d'émission du signal par l'émetteur 2 et, en parallèle, une phase 80 de réception de ce signal émis par le récepteur 4.

La phase 60 débute par une étape 62 d'acquisition des différents symboles numériques $S_j[k]$ à émettre en parallèle à un instant k sur chacun de N ports d'entrée $P_1$ à $P_N$. Chaque symbole $S_j[k]$ acquis est, typiquement, codé en binaire.

Lors d'une étape 64, pour chacun des canaux j, les symboles $S_j[k]$ reçu sur ce canal j sont modulés par le modulateur $M_j$. La modulation utilisée par le modulateur $M_j$ pour moduler un symbole numérique sur un canal est quelconque. Par exemple, il peut s'agir d'une modulation cohérente telle qu'une modulation QAM ("Quadrature Amplitude Modulation"), d'une modulation PSK ("Phase Shift Keying"). Il peut aussi s'agir d'une modulation orthogonale telle qu'une modulation FSK ("Frequency Shift Keying"), une modulation PPM ("Pulse Position Modulation") ou autres. Dans cet exemple, il s'agit d'une modulation cohérente. Dans ce cas, le signal analogique modulé $s_j(t)$ généré par le modulateur $M_j$ est exprimé par la relation (1) suivante :

$$s_j(t) = \sum_k s_j[k] \cdot g(t - kT)$$

où :

- $s_j(t)$ est le signal analogique modulé sur le canal j à l'instant t,
- $s_j[k]$ est le symbole numérique modulé à l'instant k sur le canal j,
- T est la durée d'un symbole numérique,
- g est la réponse impulsionnelle d'un filtre de mise en forme de bande limitée et d'énergie unité.

Dans cette description, le symbole "." désigne l'opération de multiplication.

À titre d'illustration, ici, le filtre de mise en forme est un filtre de mise en forme qui vérifie le critère de Nyquist. Toutefois, d'autres filtres de mise en forme sont possibles.

Pour transmettre en parallèle chaque signal $s_j(t)$, chacun des signaux $s_j(t)$ est transmis sur un canal respectif j. Pour cela, lors d'une étape 66, le circuit 10 répartie chaque signal $s_j(t)$ sur une sous-porteuse respective $\Psi_j(t)$ d'une base orthogonale $\{\Psi_j\}$ de N sous-porteuses. Cette étape de répartition des signaux modulés $s_j(t)$ sur les sous-porteuses respectives est connue sous le terme anglais de "carrier mapping" ou sous le terme d' « opérateur de synthèse » en algèbre linéaire. Le signal temporel $s_{f_i}(t)$ comportant les N sous-porteuse et codant les N signaux $s_j(t)$ transmis en parallèle est défini par la relation (2) suivante :

$$s_{f_i}(t) = \sum_j s_j(t) \cdot \psi_j(t)$$

Dans ce texte, chaque somme en fonction de l'indice j est une somme qui varie de j = 1 à j = N.

L'essentiel de la puissance du signal $s_{fi}(t)$ est comprise dans une bande intermédiaire $B_{fi}$ de fréquences. Dans ce texte, par "l'essentiel de la puissance d'un signal est compris dans une bande [$f_{min}$, $f_{max}$] de fréquences", cela signifie qu'au moins 80% ou 90% ou 95% de la puissance de ce signal est comprise dans la bande [$f_{min}$, $f_{max}$]. Autrement dit, la surface du spectre de puissance de ce signal comprise dans l'intervalle [$f_{min}$, $f_{max}$] représente plus de 80% ou 90% ou 95% de la surface totale de ce spectre de puissance. La bande intermédiaire $B_{fi}$ est centrée sur une fréquence intermédiaire notée $f_i$ par la suite. La largeur de la bande intermédiaire $B_{fi}$ est noté $L_u$ par la suite. Généralement, la fréquence $f_i$ est inférieure ou égale à $2L_u$. Par exemple, ici, la fréquence $f_i$ est comprise entre $0,5L_u$ et $1,5L_u$. La bande $B_{fi}$ est séparée de la fréquence nulle par une bande de garde. La largeur de cette bande de garde est notée $\Delta$. La puissance du signal $s_{fi}(t)$ à l'intérieur de la bande de garde est nulle ou négligeable. Ici, les fréquences $f_j$ des sous-porteuses sont choisies pour atteindre le meilleure compris possible entre les deux critères suivants :

1) La largeur $\Delta$ doit être aussi petite que possible pour maximiser l'efficacité spectrale.
2) La largeur $\Delta$ doit être assez grande pour limiter la complexité du filtre 24 et du modificateur 42. En effet, plus la largeur $\Delta$ est grande plus le filtre 24 et le modificateur 42 sont simples.

De préférence, les fréquences $f_j$ contenues dans la bande $B_{fi}$ sont des fréquences basses, c'est-à-dire, au moins deux ou cinq ou dix fois inférieure à la fréquence $f_c$. Par exemple, dans ce mode de réalisation, les fréquences $f_j$ sont inférieures à 10 GHz ou 6 GHz. En effet, les oscillateurs $Oe_j$ capables de générer de telles fréquences $f_j$ sont simples et présentent généralement un très faible bruit de phase. Dès lors, le signal $s_{fi}(t)$ qui est généré en utilisant de tels oscillateurs basses fréquences présente lui aussi un faible bruit de phase. Par la suite, ce signal $s_{fi}(t)$ est aussi appelé "signal en bande intermédiaire".

Ici, à titre d'exemple, la base orthogonale $\{\Psi_j\}$ est une base orthogonale de Fourier définie par la relation (3) suivante :

$$\Psi_j(t) = \sqrt{2} \cdot \cos(\omega_j \cdot t + \theta_j)$$

$$\omega_j = \left( m + F\left[\frac{j}{2}\right] \right) \cdot \frac{1}{T}$$

où :

- $W_j$ est égal à $2\pi f_j$, où $f_j$ est une fréquence intermédiaire choisie dans la bande intermédiaire $B_{fi}$,
- m est un entier naturel supérieur à 1,
- F[..] est la fonction partie entière ("floor function" en anglais) qui retourne la partie entière du nombre entre crochets, et
- $\theta_j$ est un déphasage initial.

Le déphasage initial $\theta_j$ est égal à $\theta_0$ lorsque j est pair et égal à $\theta_0 - \pi/2$ lorsque j est impair. De plus, par la suite, nous considérons que chaque canal j est idéalement compensé au niveau du récepteur et donc que $\theta_0$ est égal à zéro. Ici, m est choisi strictement supérieur à 1 car cela facilite le filtrage des images après la transposition en fréquences de la bande intermédiaire vers la bande haute-fréquence.

Avec cette base orthogonale $\{\Psi_j\}$, le signal $s_{fi}(t)$ est défini par la relation (4) suivante :

$$s_{f_i}(t) = \sum_j s_j(t) \cdot \sqrt{2} \cos\left(\omega_j \cdot t + \theta_j\right)$$

Étant donné que le bruit de phase des oscillateurs qui génèrent les porteuses aux fréquences $f_j$ est très faible, il est négligé dans les relations qui suivent.

Avant la transposition du signal $s_{fi}(t)$ de la bande intermédiaire $B_{fi}$ vers la bande haute-fréquence, lors d'une étape 68, l'additionneur 16 ajoute une constante $v_0$ au signal $s_{fi}(t)$ pour obtenir le signal $s_{DC}(t)$. Le signal $s_{DC}(t)$ est donc défini par la relation suivante :

$$s_{DC}(t) = s_{f_i}(t) + v_0$$

De plus, la constante $v_0$ est choisie de manière à vérifier la relation (6) suivante et cela pour toutes les valeurs possibles de t :

$$v_0 \geq -\min_{t \in R} s_{f_i}(t)$$

où "min $s_{fi}(t)$" est la fonction qui retourne la plus petite valeur du signal $s_{fi}(t)$ lorsque t appartient à l'ensemble des nombres réels positifs. Dans ces conditions, le signal $s_{DC}(t)$ est un signal qui est toujours supérieur ou égal à zéro. Dès lors, ce signal $s_{DC}(t)$ peut être utilisé pour moduler l'enveloppe d'une porteuse dans la bande haute-fréquence. Par exemple, pour cela le signal $s_{DC}(t)$ est directement utilisé pour commander un amplificateur de la puissance de la porteuse haute-fréquence.

Lors d'une étape 70, le multiplieur 20 réalise une transposition en fréquence. La transposition en fréquence permet de déplacer le signal $s_{fi}(t)$ de la bande intermédiaire $B_{fi}$ vers une bande haute-fréquence. Cette transposition transforme le signal $s_{fi}(t)$ en un signal $s_{fc}(t)$ située dans la bande haute-fréquence. Le signal $s_{fc}(t)$ est défini par la relation (7) suivante :

$$s_{f_c}(t) = s_{DC}(t) \cdot \cos\left(w_c \cdot t + \phi_{f_c}(t)\right),$$

où :

- $w_c$ est égal à $2\pi f_c$, où $f_c$ est la fréquence de la porteuse haute-fréquence générée par l'oscillateur 22,
- $\Phi_{fc}(t)$ est le bruit de phase introduit par l'oscillateur 22 qui génère la porteuse à la fréquence $f_c$.

La fréquence $f_c$ est située dans la bande haute-fréquence. Le bruit de phase $\Phi_{fc}(t)$ de l'oscillateur qui génère la porteuse à la fréquence $f_c$ est donc généralement important.

La relation (7) peut aussi s'écrire à l'aide de la relation (8) suivante :

$$s_{f_c}(t) = \sum_j s_j(t) \cdot \frac{\sqrt{2}}{2} \left( \cos\left((w_c + w_j).t + \theta_j + \phi_{f_c}(t)\right) + \cos\left((w_c - w_j).t - \theta_j - \phi_{f_c}(t)\right) \right) + v_0 \cos\left(w_c \cdot t + \phi_{f_c}(t)\right)$$

La relation (8) montre que l'essentiel de la puissance du spectre de puissance du signal $s_{fc}(t)$ se répartie entre :

- une composante d'amplitude $v_0$ à la fréquence $f_c$,
- une bande latérale basse fréquence située à gauche de la fréquence $f_c$ et constituée par les termes comportant l'expression $(w_c - w_j).t$, et
- une bande latérale haute fréquence située à droite de la fréquence $f_c$ et constituée par les termes comportant l'expression $(w_c + w_j).t$.

Chacune de ces bandes latérales contient une image du signal utile, c'est-à-dire ici une image du signal $s_{fi}(t)$.

Ici, lors d'une étape 72, pour améliorer l'efficacité spectrale, la bande latérale basse fréquence est éliminée afin d'obtenir un signal s(t) à bande latérale unique. ou SSB ("Single Side Band"). Pour cela, le signal $s_{fc}(t)$ est filtré par le filtre 24. Le signal s(t) filtré est défini par la relation (9) suivante :

$$s(t) = s_{f_c}(t) * g_h(t)$$

où :

- \* est le symbole de l'opération de convolution, et
- gh(t) est la réponse impulsionnelle du filtre 24.

De plus, pour limiter la consommation d'énergie de l'émetteur, lors de l'étape 72, la puissance de la porteuse à la fréquence $f_c$ est également diminuée pour diminuer le rapport $P_c/P_s$, où :

- $P_c$ est la puissance de la porteuse à la fréquence $f_c$, et
- $P_s$ est la puissance du signal utile dans bande latérale haute fréquence.

Ici, le filtre 24 est apte à diminuer la puissance $P_c$ de sorte que le rapport $P_c/P_s$ soit inférieur à trois et, de préférence, inférieur ou égal à un. Ici, le filtre 24 est configuré pour que le rapport $P_c/P_s$ soit compris entre 0,1 et 1 ou entre 0,3 et 0,9. Par exemple, ici le filtre 24 est telle que le rapport $P_c/P_s$ est égal à 0,9.

Pour cela, ici, le filtre 24 est un filtre passe bande. La fréquence de coupure basse $f_{cb24}$ à -3 dB du filtre 24 est typiquement comprise entre $f_c$ et $f_c+\Delta$ ou entre $f_c$ et $f_c+\Delta/2$, où $\Delta$ est la largeur de la bande de garde. Sa fréquence de coupure haute $f_{ch24}$ à -3 dB est supérieure à $f_c+\Delta+L_u$. Après la transposition en fréquence, la bande de garde s'étend depuis la fréquence $f_c$ jusqu'au début de la bande latérale haute fréquence. À l'intérieur de la bande de garde la puissance du signal $s_{fc}(t)$ est négligeable ou nulle.

Le signal s(t) obtenu à l'issu de l'étape 72 est défini par la relation (10) suivante :

$$s(t) = \sum_j s_j(t) \cdot \sqrt{2} . \cos\left(\left(w_c + w_j\right)t + \theta_j + \phi_{f_c}(t)\right) + v_1 \cos\left(w_c \cdot t + \phi_{f_c}(t)\right)$$

où $v_1$ est l'amplitude de la porteuse à la fréquence $f_c$.

Ici, le filtre 24 possède une énergie de 2 pour compenser le facteur 1/2 de la relation (8).

L'amplitude $v_1$ est inférieure ou égale à l'amplitude $v_0$. L'essentiel de l'énergie du signal s(t) est comprise dans une bande haute-fréquence $B_{tot}$ comprise entre une fréquence $f_{min}$ et une fréquence $f_{max}$. La fréquence $f_{min}$ est égale à la fréquence $f_c$. La fréquence $f_{max}$ est égale à $f_c+f_i+L_u/2$. La fréquence $f_{max}$ est aussi égale à $f_c+\Delta+L_u$.

Lors d'une étape 74, le signal s(t) est émis vers le récepteur 4 par l'intermédiaire du point 26. Ici, le signal s(t) est émis dans l'air par l'antenne vers le récepteur 4 en ligne de vue direct.

Les étapes 62 à 44 sont réitérées pour chaque symbole numérique à transmettre.

En parallèle de la phase 60 d'émission, le récepteur exécute la phase 80 de réception du signal s(t).

Lors d'une étape 82, le récepteur 4 reçoit le signal r(t) par l'intermédiaire de l'antenne réceptrice du point 30 d'entrée.

La propagation du signal s(t) dans l'air introduit un bruit b(t) dans ce signal. Dans la bande haute-fréquence, le bruit b(t) peut être modélisé par un bruit blanc additif gaussien. Le bruit blanc b(t) est un processus stochastique stationnaire de moyenne nulle et de densité spectrale $N_0$. Le signal r(t) reçu est donc défini par la relation (11) suivante:

$$r(t) = s(t) + b(t)$$

Lors d'une étape 84, tout d'abord, le signal r(t) est filtré par le filtre 32. Le filtre 32 est configuré pour éviter le repliement du spectre du bruit b(t) qui s'étend au-delà de la bande $B_{tot}$ dans le récepteur. En effet, un tel repliement dégraderait le rapport signal sur bruit à l'intérieur du récepteur. À cet effet, le filtre 32 est un filtre passe bande. La bande passante du filtre 32 est suffisamment grande pour englober complètement la bande $B_{tot}$ et suffisamment petite pour atténuer autant que possible le bruit situé en dehors de la bande $B_{tot}$. La bande passante du filtre 32 s'étend entre deux fréquences de coupure à - 3 dB notées, respectivement, $f_{c32min}$ et $f_{c32max}$. Par exemple, la fréquence $f_{c32min}$ est comprise entre $f_{mm-\Delta}$ et $f_{min}$. La fréquence $f_{c32max}$ est comprise entre $f_{max}$ et $f_{max}+\Delta$. L'opération réalisée par le filtre 32 afin d'obtenir le signal filtré rb(t) est définie par la relation (12) suivante:

$$r_b(t) = r(t) * g_b(t)$$

où $g_b(t)$ est la réponse impulsionnelle du filtre 32.

Le signal $r_b(t)$ obtenu à la sortie du filtre 32 est approximée par la relation (13) suivante :

$$r_b(t) = r(t) + b'(t)$$

où $b'(t)$ est le bruit introduit par le canal de transmission est situé à l'intérieur de la bande $B_{tot}$. Le bruit $b'(t)$ est donc un bruit de bande limitée à la bande $B_{tot}$.

Lors d'une étape 86, le circuit 34 de détection d'enveloppe reçoit le signal $r_b(t)$ et réalise une transposition de fréquences de ce signal $r_b(t)$ dans la bande intermédiaire. De plus, ici, le circuit 34 est conçu pour atténuer le fort bruit de phase $\Phi_{fc}(t)$. Le fonctionnement détaillé du circuit 34 est décrit plus loin en référence à la figure 5.

Le signal $r_{fi}(t)$ délivré par le circuit 34 est défini par la relation (14) suivante :

$$r_{f_i}(t) = Q\left(r_b(t)\right)$$

où Q est la fonction qui représente les opérations réalisée par le circuit 34 pour extraire l'enveloppe du signal rb(t).

L'enveloppe $r_{fi}(t)$ détectée par le circuit 34 peut être exprimée sous la forme de la relation (15) suivante :

$$r_{f_i}(t) = c + b'(t) + \sum_j s_j(t) \cdot \sqrt{2} \cos\left(w_j \cdot t + \theta_j\right)$$

où "c" est une constante dont l'origine est expliquée plus loin en référence à la figure 5.

Lors d'une étape 88, le circuit 36 réalise l'opérateur d'analyse (terme issu de l'algèbre linéaire, ou « carrier demapping » en anglais) des différentes sous-porteuses les unes des autres. Pour cela, pour chaque canal j, le circuit 36 réalise l'opération définie de façon générique par la relation (16) suivante :

$$r_j(t) = r_{f_i}(t) \cdot \psi_j(t)$$

Dans le cas particulier de la base orthogonale de Fourier utilisée par l'émetteur 2, la relation (16) s'écrit également sous la forme de la relation (17) suivante :

$$r_j(t) = r_{f_i}(t) \cdot \sqrt{2} \cos\left(w_j \cdot t + \theta_j + \phi_{f_i}(t)\right)$$

où $\Phi_{fi}(t)$ est le bruit de phase introduit par l'oscillateur $O_{rj}$ qui génère la porteuse à la fréquence $f_j$. Étant donné que les fréquences intermédiaire $f_j$ sont beaucoup plus petites que la fréquence $f_c$, le bruit de phase $\Phi_{fi}(t)$ est petit et négligeable.

La relation (17) s'écrit aussi sous la forme de la relation (18) suivante :

$$r_j(t) = \left(b'(t) + c\right) \cdot \sqrt{2} \cos\left(w_j \cdot t + \theta_j + \phi_{f_i}(t)\right)$$
$$+ \sum_{n_0} s_{n_0}(t) \cdot \cos\left((w_{n_0} - w_j)t + (\theta_{n_0} - \theta_j) - \phi_{f_i}\right)$$
$$+ \sum_{n_0} s_{n_0}(t) \cdot \cos\left((w_{n_0} + w_j)t + (\theta_{n_0} + \theta_j) + \phi_{f_i}\right($$

où l'indice $n_0$ est un indice qui varie de 1 à N.

La constante "c" présente dans la relation (18) n'a aucun impact puisque sa projection sur $\Psi_j(t)$ est nulle.

Enfin, lors d'une étape 90, pour chaque canal j, le symbole $S_j[k]$ modulé à l'instant k sur le canal j est démodulé,

par le démodulateur D$_j$. Le démodulateur D$_j$ est par exemple conventionnel. Typiquement, l'opération réalisée par le démodulateur D$_j$ est définie par la relation (18) suivante :

$$\hat{s}_j[k] = r_j(t) * g^*(-t), t = kT$$

où :

- $\hat{s}_j$[k] est l'estimation du symbole S$_j$[k] construite par le démodulateur Dj, et
- g*(t) est la réponse impulsionnelle du filtre adapté.

Enfin, lors d'une étape 92, chaque symbole estimé $\hat{s}_j$[k] est délivré sur son port de respectif P$_{sj}$.
Les étapes 82 à 92 sont réitérées pour chacun des symboles numériques émis.
Le fonctionnement du circuit 34 est maintenant décrit plus en détail en référence au procédé de la figure 5.
Lors d'une étape 100, le circuit 34 reçoit le signal rb(t) sur son port P$_{e34}$. Par la suite, pour expliquer le fonctionnement du circuit 34, le bruit b'(t) dans le signal rb(t) est négligé. Le signal r$_b$(t) dans lequel le bruit a été négligé est noté s$_{v1}$(t). Le signal s$_{v1}$(t) est défini par la relation (19) suivante :

$$s_{v_1}(t) = \sum_j s_j(t) \cdot \sqrt{2} \cos\left(\left(w_c + w_j\right)t + \theta_j + \phi_{f_c}(t)\right) + v_1 \cos\left(w_c \cdot t + \phi_{f_c}(t)\right)$$

Par la suite, ce signal s$_{v1}$(t) est écrit sous la forme définie par la relation (20) suivante :

$$s_{v_1}(t) = s_{f_c+}(t) + v_1 \cos\left(w_c \cdot t + \phi_{f_c}(t)\right)$$

où s$_{fc+}$(t) correspond aux termes en cos(w$_c$+w$_j$) de la relation (19), c'est-à-dire au signal utile contenu dans la bande latérale haute fréquence.
Lors d'une étape 102, le signal s$_{v1}$(t) est dupliqué pour obtenir deux exemplaires identiques de ce signal. Chaque exemplaire du signal s$_{v1}$(t) est ensuite traité en parallèle dans deux branches séparées du circuit 34.
Lors d'une étape 104, la copie du signal s$_{v1}$(t) qui emprunte la branche du haut dans le schéma représenté dans la figure 3, est multiplié par lui-même par le multiplieur 40 pour obtenir un signal s$_{v1}$(t)$^2$. Le multiplieur 40 réalise donc l'opération définie par la relation (21) suivante :

$$s_{v_1}(t)^2 = s_{f_c+}(t)^2 + 2 s_{f_c+}(t) v_1 \cos\left(w_c \cdot t + \phi_{f_c}(t)\right) + v_1^2 \cdot \cos\left(w_c \cdot t + \phi_{f_c}(t)\right)^2$$

Le terme du milieu dans la relation (21) peut également s'écrire sous la forme définie par la relation (22) suivante :

$$s_{f_c+}(t) . \cos\left(w_c \cdot t + \phi_{f_c}(t)\right) = \frac{1}{2} \sum_j s_j(t) \cdot \sqrt{2} \cos\left(w_j t + \theta_j\right) + \frac{1}{2} \sum_j s_j(t) \cdot \sqrt{2} \cos\left(\left(2 w_c + w_j\right)t + \theta_j + 2\phi_{f_c}(t)\right)$$

Ainsi, ce terme du milieu de la relation (21) s'écrit également sous la forme abrégée définie par la relation (23) suivante :

$$s_{f_c+}(t) . \cos\left(w_c \cdot t + \phi_{f_c}(t)\right) = \frac{s_{f_i}(t)}{2} + \frac{s_{2f_c}(t)}{2}$$

où s$_{2fc}$(t) correspond aux termes en cos(2w$_c$+w$_j$)t de la relation (22).
En parallèle, dans la branche inférieure du circuit 34, lors d'une étape 106, la copie du signal s$_{v1}$(t) est filtrée par le modificateur 42 pour obtenir un signal s$_{v2}$(t). Le signal s$_{v2}$(t) est identique au signal s$_{v1}$(t) sauf que la constante

$\nu_1$ est remplacée par une constante $\nu_2$ différente. Ici, la constante $\nu_2$ est plus petite que la constante $\nu_1$. À cet effet, le modificateur 42 est configuré pour atténuer la puissance de la porteuse à la fréquence $f_c$ sans affecter le signal utile qui se trouve dans la bande latérale haute fréquence. Par exemple, pour cela, le modificateur 42 est un filtre passe haut dont la fréquence de coupure $f_{c42}$ à -3 dB est comprise entre $f_c$ et $f_c+\Delta$ ou entre $f_c$ et $f_c+\Delta/2$, où $\Delta$ est la largeur de la bande de garde qui s'étend depuis la fréquence $f_c$ jusqu'au début de la bande latérale haute fréquence.

Ensuite, lors d'une étape 108, le signal $s_{v2}(t)$ est multiplié par lui-même par le multiplieur 44 pour obtenir un signal $s_{v2}(t)^2$. Cette étape est identique à l'étape 104 sauf que le signal multiplié par lui-même est le signal $s_{v2}(t)$ au lieu du signal $s_{v1}(t)$.

Lors d'une étape 110, les signaux $s_{v1}(t)^2$ et $s_{v2}(t)^2$ sont soustrait l'un à l'autre, par le soustracteur 46, pour obtenir le signal $d_{fi}(t)$. Le soustracteur 46 exécute donc l'opération définie par la relation (24) suivante :

$$s_{v_1}(t)^2-s_{v_2}(t)^2=\frac{v_1^2-v_2^2}{2}\left(1+\cos\left(2w_ct+2\phi_{f_c}(t)\right)\right)+(v_1-v_2)\left(s_{f_i}(t)+s_{2f_c}(t)\right)$$

Lors d'une étape 112, le signal dfi(t) est divisé par une constante égale à $(\nu_1-\nu_2)$ par le diviseur 48 pour obtenir un signal $s_{fi+}(t)$. Le diviseur 48 réalise donc l'opération définie par la relation (25) suivante :

$$s_{f_{i+}}(t)=\frac{s_{v_1}(t)^2-s_{v_2}(t)^2}{v_1-v_2}=s_{f_i}(t)+\frac{v_1+v_2}{2}+s_{2f_c}(t)+\frac{v_1+v_2}{2}\cos\left(2w_c\cdot t+2\phi_{f_c}(t)\right)$$

La relation (25) montre que le signal $s_{fi+}(t)$ se compose du signal utile $s_{fi}(t)$ additionné à une constante $(\nu_1+\nu_2)/2$ et des signaux de fréquences supérieures ou égales à $2f_c$.

Lors d'une étape 114, le filtre 50 élimine les composantes du signal $s_{fi+}(t)$ dont les fréquences sont supérieures ou égale à $2f_c$ pour obtenir le signal $r_{fi}(t)$. À cet effet, ici, le filtre 50 est un filtre passe haut dont la fréquence de coupure $f_{c50}$ à -3 dB est comprise entre $f_i+L_u/2$ et $2f_c$. Dans ces conditions, le filtre 50 n'élimine pas la constante $(\nu_1+\nu_2)/2$ dont l'effet est éliminé par l'opérateur d'analyse défini par la relation (16). Le filtre 50 exécute donc l'opération définie par la relation suivante :

$$r_{f_i}(t)=s_{f_{i+}}(t)*g_l(t)$$

où $g_l(t)$ est la réponse impulsionnelle du filtre 50.

Ainsi, en sortie du filtre 50, le signal $r_{fi}(t)$ est celui définie par la relation (15) introduire précédemment. Le circuit 34 permet donc bien de faire une transposition du signal utile de la bande haute-fréquence vers la bande intermédiaire sans pour cela utiliser un oscillateur local qui génère un signal à la fréquence $f_c$.

Lors d'une étape 116, le signal $r_{fi}(t)$ est délivré sur le port de sortie $P_{s34}$.

Chapitre II : Variantes

Ce qui a été décrit dans le cas particulier d'une transmission sans fil du signal modulé s(t) entre l'émetteur et le récepteur peut aussi s'appliquer au cas où le signal s(t) se propage à l'intérieur d'une liaison filaire reliant le point de sortie de l'émetteur au point d'entrée du récepteur. Par exemple, cette liaison filaire est une fibre optique.

Dans un mode de réalisation simplifié, le nombre N de sous-porteuses est égal à un. Dans ce cas, l'émetteur 2 comporte un seul modulateur $M_1$, un seul multiplieur $X_{e1}$, un seul oscillateur $O_{e1}$. L'additionneur 14 est omis et la sortie du multiplieur $X_{e1}$ est directement raccordée à l'entrée de l'additionneur 16. De façon correspondante, le récepteur comporte un seul multiplieur $X_{r1}$, un seul oscillateur $O_{r1}$ et un seul démodulateur $D_1$.

Dans le cas où les symboles numériques sont modulés par modulation orthogonale sur une sous-porteuses j par le modulateur $M_j$, le signal temporelle $S_j(t)$ est donné par la relation suivante :

$$s_j(t)=\sum_k \varphi_{i_j[k]}(t-kT)$$

où :

- $i_j[k]$ est l'indice modulé à l'instant k sur la porteuse j,
- $\{\varphi i()\}$ est un ensemble de signaux orthogonaux appartenant à $L^2([0, T])$.

Dans le cas où une modulation orthogonale est utilisée sur le canal j, le démodulateur $D_j$ doit être adapté de façon correspondante. Par exemple, le démodulateur $D_j$ est dans ce cas un bloc de corrélation. Un tel bloc de corrélation est par exemple décrit dans le document suivant : John G. Proakis : "Digital Communication", 4ième édition.

Il est possible d'utiliser d'autres bases orthogonales qu'une base orthogonale de Fourier comme décrit dans l'exemple précédent. Par exemple, il est aussi possible d'utiliser une base orthogonale d'Hadamard ou une base orthogonale polynomiale ou encore une base d'ondelettes. Pour obtenir des références bibliographiques d'implémentation d'une base orthogonale polynomiale, le lecteur peut consulter l'article suivant : M. Srinivasan, "Comparision of prime codes, extended prime codes and quadratic congruence code using normalized throughput metric", Transparent Optical Networks, 2004. Proceedings of 2004 6th International Conférence on, vol 2, pp 168-171, 4-8 juil 2004.

Lors de l'étape 72, il est possible d'éliminer la bande latérale haute fréquence et ainsi conserver la bande latérale basse fréquence. On obtient alors aussi dans ce cas un signal avec une seule bande latérale. Le procédé de réception décrit doit alors être adapté pour tenir compte du fait que la bande latérale qui contient le signal utile se trouve maintenant à gauche, et non plus à droite, de la fréquence $f_c$. En particulier, le filtre 24 doit être adapté pour atténuer l'amplitude de la porteuse à la fréquence $f_c$ sans atténuer le signal utile. Par exemple, dans ce cas, le filtre 24 est un filtre passe-bas et non plus un filtre passe-haut. Sa fréquence de coupure $f_{c24}$ est choisie pour atténuer l'amplitude $v_0$ sans atténuer le signal utile.

Dans un autre mode de réalisation, le signal émis comporte à la fois les bandes latérales haute fréquence et basse fréquence. Pour cela, la réponse impulsionnelle du filtre gh(t) du filtre 24 est adaptée pour obtenir un signal s(t) comportant les deux bandes latérales. Par exemple, le filtre 24 est un filtre passe-bande qui atténue uniquement la puissance de la porteuse à la fréquence $f_c$ sans modifier la puissance du signal utile dans les bandes latérales. Le récepteur précédemment décrit est apte à recevoir un tel signal s(t) et peut donc être laissé inchangé. Toutefois, dans ce cas, à cause du filtre 32, seul le signal utile dans l'une des deux bandes latérales du signal reçu est exploité par ce récepteur. En variante, le filtre 32 est modifié pour laisse passer les deux bandes latérales. Dans ce dernier cas, le modificateur 42 du circuit 34 doit aussi être adapté pour atténuer l'amplitude $v_1$ de la porteuse à la fréquence $f_c$ sans atténuer le signal utile compris dans les bandes latérales haute et basse fréquences du signal reçu. Le récepteur ainsi adapté exploite alors le signal utile compris dans les deux bandes latérales du signal reçu.

Dans un mode de réalisation très simplifié, le filtre 24 n'atténue pas non plus l'amplitude de la porteuse à la fréquence $f_c$. Dans ce cas, la constante $v_1$ est égale à la constante $v_0$.

Dans un mode de réalisation simplifié, le diviseur 48 est omis. Dans ce cas, le signal $r_{fi}(t)$ délivré par le circuit 34 n'a pas la même amplitude que le signal $s_{fi}(t)$ émis. Toutefois, cette différence d'amplitude entre le signal émis et le signal à démoduler peut être corrigée ultérieurement dans la chaîne de réception du signal. Par exemple, cette différence d'amplitude peut aussi être corrigée par le circuit 36 ou par les démodulateur $D_j$.

En variante, le filtre 50 peut aussi être un filtre passe-bande configuré pour éliminer à la fois les composantes du signal $s_{fi+}(t)$ dont les fréquences sont supérieures ou égales à $2f_c$ mais aussi la constante $(v_1+v_2)/2$.

Les différentes variantes décrites ici peuvent être combinées entre elles.

Chapitre III: Avantages des modes de réalisation décrits

Le circuit 34 permet de transposer le signal utile contenu dans une bande latérale haute-fréquence vers la bande intermédiaire sans utiliser d'oscillateur local qui génère une porteuse à la fréquence $f_c$ comme c'est habituellement le cas. De plus, le circuit 34 est plus simple que celui divulgué dans l'article de Voelcker. En particulier, le circuit 34 permet de réaliser la transposition de fréquences sans faire intervenir une transformée de Hilbert. Enfin, contrairement au récepteur divulgué dans l'article de Voelcker, le circuit 34 est capable de traiter correctement un signal reçu r(t) dans lequel la constante $v_1$ ne satisfait pas la condition énoncée par la relation (6). Par conséquent, le circuit 34 est capable de traiter des signaux de meilleur efficacités énergétique que ceux susceptibles d'être traités par le récepteur de l'article de Voelcker. Ce sont les calculs et les hypothèses faites dans l'article de Voelcker qui font que le circuit décrit dans cet article ne peut fonctionner que si, dans le signal reçu, la puissance de la porteuse à la fréquence $f_c$ est beaucoup plus importante que la puissance du signal utile. Il a été estimé que le circuit décrit dans l'article de Voelcker fonctionne correctement que si la puissance de la porteuse à la fréquence $f_c$ est au moins trois ou quatre fois supérieure à la puissance du signal utile.

Le diviseur 48 permet au circuit 34 de délivrer sur sa sortie un signal $r_{fi}(t)$ dans lequel l'amplitude du signal utile $s_{fi}(t)$ est identique à l'amplitude du signal utile émis. Il n'est donc pas nécessaire de corriger ailleurs l'amplitude du signal $r_{fi}(t)$.

Grâce au circuit 34, le récepteur 4 est capable de réaliser une démodulation cohérente en s'affranchissant de l'impact du bruit de phase des oscillateurs hautes-fréquence sur les performances des communications.

Grâce au circuit 36 d'isolation de sous-porteuses, la fréquence des symboles à démoduler transmis sur chacune de ces sous-porteuses est diminuée. Cela permet donc d'utiliser des démodulateurs $D_j$, plus lent tout en conservant un débit de transmission d'informations sur la liaison entre l'émetteur 2 et le récepteur 4 très élevé.

Le fait que l'émetteur atténue la puissance $P_c$ de la porteuse à la fréquence $f_c$ de manière à obtenir un signal s(t) dans lequel la puissance $P_c$ est inférieure ou égale à la puissance $P_s$ du signal utile dans ce même signal s(t) permet d'améliorer l'efficacité énergétique de l'émetteur 2 par rapport à celui décrit dans l'article de Voelcker.

Le fait d'émettre un signal à bande latérale unique limite la consommation d'énergie de l'émetteur 2 et améliore l'efficacité spectrale.

**Revendications**

**1.** Circuit de détection d'enveloppe pour un signal modulé dans une bande haute-fréquence, c'est-à-dire une bande de fréquences située au-delà de 30 GHz, ce circuit comportant :

- un port d'entrée ($P_{e34}$) apte à recevoir le signal modulé dans la bande haute-fréquence, ce signal modulé comportant une enveloppe modulée par une porteuse à une fréquence $f_c$ prédéterminée comprise dans la bande haute-fréquence, l'enveloppe comportant une constante $v_1$ additionnée à un signal utile $s_{fi}(t)$, l'essentiel de la puissance du signal utile $s_{fi}(t)$ étant comprise à l'intérieur d'une bande utile de fréquences centrée sur une fréquence intermédiaire $f_i$ et de largeur $L_u$,
- un port de sortie ($P_{s34}$) par l'intermédiaire duquel est délivré l'enveloppe détectée pour le signal modulé,
- un premier multiplieur (40) raccordé au port d'entrée et apte :

  • à multiplier un premier exemplaire du signal reçu sur le port d'entrée par lui-même, et
  • à délivrer sur une sortie ce premier exemplaire du signal reçu multiplié par lui-même,

- un modificateur (42) raccordé, en parallèle du premier multiplieur, au port d'entrée, ce modificateur étant apte :

  • à modifier l'amplitude du spectre de puissance, d'un second exemplaire du signal reçu sur le port d'entrée, à la fréquence $f_c$ sans modifier l'amplitude de ce spectre de puissance dans la bande utile de fréquences, et
  • à délivrer sur une sortie le signal modifié,

- un second multiplieur (44) raccordé à la sortie du modificateur et apte :

  • à multiplier le signal modifié par lui-même, et
  • à délivrer sur une sortie le signal modifié multiplié par lui-même,

- un soustracteur (46) comportant une première entrée et une seconde entrée raccordées, respectivement, aux sorties des premier et second multiplieurs, ce soustracteur étant apte :

  • à soustraire le signal reçu sur sa première entrée du signal reçu sur sa seconde entrée, et
  • à délivrer sur une sortie le résultat de cette soustraction,

- un filtre (50) apte à éliminer les composantes de fréquence supérieure ou égale à $2f_c$ dans un signal obtenu à partir du signal délivré par la sortie du soustracteur, ce filtre comportant à cet effet une fréquence de coupure à - 3 dB comprise entre $f_i+L_u/2$ et $2f_c$, ce filtre étant apte à délivrer le résultat de ce filtrage en tant que l'enveloppe détectée pour le signal modulé sur une sortie raccordée au port de sortie du circuit de détection d'enveloppe.

**2.** Circuit selon la revendication 1, dans lequel le circuit comporte un diviseur (48) d'amplitude raccordé entre la sortie du soustracteur (46) et une entrée du filtre (50), ce diviseur étant apte à diviser l'amplitude du signal délivré sur la sortie du soustracteur par une constante égale à $(v_1-v_2)$ et à délivré sur l'entrée du filtre (50) le signal ainsi divisé, les constantes $v_1$ et $v_2$ étant égales aux amplitudes des porteuses à la fréquence $f_c$ dans les signaux délivrés en entrée, respectivement, des premier et second multiplieurs.

**3.** Récepteur pour recevoir un signal modulé comportant une enveloppe modulée par une porteuse à une fréquence $f_c$ prédéterminée comprise dans une bande haute-fréquence, l'enveloppe comportant une constante $v_1$ additionnée

à un signal utile $s_{fi}(t)$, l'essentiel de la puissance du signal utile $s_{fi}(t)$ étant comprise à l'intérieur d'une bande utile de fréquences centrée sur une fréquence intermédiaire $f_i$ prédéterminée et de largeur $L_u$, ce récepteur comportant :

- un point (30) d'entrée du signal modulé reçu dans la bande haute-fréquence,
- un filtre passe-bande (32) raccordé au point (30) d'entrée, ce filtre passe bande étant apte :

  • à atténuer le bruit qui se trouve, dans le signal modulé reçu, en dehors de la bande utile et de la fréquence $f_c$, et
  • à délivrer sur une sortie un signal filtré,

**caractérisé en ce que** le récepteur comporte un circuit (34) de détection d'enveloppe comportant un port d'entrée ($P_{e34}$) raccordé à la sortie du filtre passe-bande (32) et un port de sortie ($P_{s34}$) sur lequel est délivrée l'enveloppe détectée, ce circuit (34) de détection d'enveloppe étant conforme à la revendication 1.

4. Récepteur selon la revendication 3, dans lequel le récepteur comporte :

   - un circuit (36) d'isolation de sous-porteuses raccordé au port de sortie du circuit (34) de détection d'enveloppe, ce circuit (36) d'isolation de sous-porteuses étant aptes à séparer les uns des autres différents signaux transmis simultanément par l'intermédiaire de différentes sous-porteuses toutes situées à l'intérieure de la bande utile de fréquences, et
   - des démodulateurs ($D_i$) raccordées à des sorties respectives du circuit d'isolation et aptes chacun à démoduler le signal isolé sur une sous-porteuse.

5. Récepteur selon la revendication 3 ou 4, dans lequel le point (30) d'entrée est une antenne apte à recevoir le signal modulé par l'intermédiaire d'une liaison sans fil

6. Procédé de détection d'enveloppe pour un signal modulé dans une bande haute-fréquence, c'est-à-dire une bande de fréquences située au-delà de 30 GHz, ce procédé comportant :

   - la réception (100) sur un port d'entrée du signal modulé dans la bande haute-fréquence, ce signal modulé comportant une enveloppe modulée par une porteuse à une fréquence $f_c$ prédéterminée comprise dans la bande haute-fréquence, l'enveloppe comportant une constante $v_1$ additionnée à un signal utile $s_{fi}(t)$, l'essentiel de la puissance du signal utile $s_{fi}(t)$ étant comprise à l'intérieur d'une bande utile de fréquences centrée sur une fréquence intermédiaire $f_i$ et de largeur $L_u$,
   - la multiplication (104) d'un premier exemplaire du signal reçu sur le port d'entrée par lui-même,
   - en parallèle, la modification (106) d'un second exemplaire du signal reçu sur le port d'entrée de manière à obtenir un signal modifié dans lequel l'amplitude de la porteuse à la fréquence $f_c$ est modifiée alors que l'amplitude du signal utile est laissée inchangée, puis
   - la multiplication (108) du signal modifié par lui-même,
   - la soustraction (110) du signal modifié multiplié par lui-même au premier exemplaire du signal reçu multiplié par lui-même pour obtenir un signal $d_{fi}(t)$,
   - le filtrage (114) des composantes de fréquence supérieure ou égale à $2f_c$ dans le signal $d_{fi}(t)$ à l'aide d'un filtre comportant à cet effet une fréquence de coupure à - 3 dB comprise entre $f_i+L_u/2$ et $2f_c$ et la délivrance du résultat de ce filtrage en tant que l'enveloppe détectée pour le signal modulé sur un port de sortie ($P_{s34}$).

**Patentansprüche**

1. Hüllkurvenerfassungsschaltung für ein in einem Hochfrequenzband, d.h. einem Frequenzband oberhalb von 30 GHz, moduliertes Signal, wobei diese Schaltung aufweist:

   - einen Eingangsport ($P_{e34}$), der geeignet ist, das im Hochfrequenzband modulierte Signal zu empfangen, wobei dieses modulierte Signal eine durch einen Träger auf eine im Hochfrequenzband enthaltene vorbestimmte Frequenz $f_c$ modulierte Hüllkurve aufweist, wobei die Hüllkurve eine zu einem Nutzsignal $s_{fi}(t)$ addierte Konstante $v_1$ aufweist, wobei der wesentliche Teil der Leistung des Nutzsignals $s_{fi}(t)$ sich innerhalb eines nutzbaren Frequenzbands befindet, das auf eine Zwischenfrequenz $f_i$ zentriert ist und eine Breite $L_u$ hat,
   - einen Ausgangsport ($P_{s34}$), mittels dessen die für das modulierte Signal erfasste Hüllkurve geliefert wird,
   - einen ersten Multiplizierer (40), der an den Eingangsport angeschlossen und geeignet ist:

• ein erstes Exemplar des am Eingangsport empfangenen Signals mit sich selbst zu multiplizieren, und
• an einem Ausgang dieses erste Exemplar des empfangenen, mit sich selbst multiplizierten Signals zu liefern,

- einen Modifizierer (42) , der parallel zum ersten Multiplizierer an den Eingangsport angeschlossen ist, wobei dieser Modifizierer geeignet ist:

• die Amplitude des Leistungsspektrums eines zweiten Exemplars des am Eingangsport empfangenen Signals auf die Frequenz $f_c$ zu modifizieren, ohne die Amplitude dieses Leistungsspektrums im nutzbaren Frequenzband zu modifizieren, und
• das modifizierte Signal an einem Ausgang zu liefern,

- einen zweiten Multiplizierer (44), der an den Ausgang des Modifizierers angeschlossen und geeignet ist:

• das modifizierte Signal mit sich selbst zu multiplizieren, und
• das mit sich selbst multiplizierte modifizierte Signal an einem Ausgang zu liefern,

- einen Subtrahierer (46), der einen ersten Eingang und einen zweiten Eingang aufweist, die an die Ausgänge der ersten bzw. zweiten Multiplizierer angeschlossen sind, wobei dieser Subtrahierer geeignet ist:

• das an seinem ersten Eingang empfangene Signal von dem an seinem zweiten Eingang empfangenen Signal zu subtrahieren, und
• das Ergebnis dieser Subtraktion an einem Ausgang zu liefern,

- ein Filter (50), das geeignet ist, die Frequenzkomponenten höher als oder gleich $2f_c$ in einem Signal zu entfernen, das ausgehend von dem vom Ausgang des Subtrahierers gelieferten Signal erhalten wird, wobei dieses Filter zu diesem Zweck eine Grenzfrequenz bei -3dB zwischen $f_i+L_u/2$ und $2f_c$ aufweist, wobei dieses Filter geeignet ist, das Ergebnis dieser Filterung als die erfasste Hüllkurve für das modulierte Signal an einem an den Ausgangsport der Hüllkurvenerfassungsschaltung angeschlossenen Ausgang zu liefern.

**2.** Schaltung nach Anspruch 1, wobei die Schaltung einen Amplitudenteiler (48) aufweist, der zwischen dem Ausgang des Subtrahierers (46) und einem Eingang des Filters (50) angeschlossen ist, wobei dieser Teiler geeignet ist, die Amplitude des am Ausgang des Subtrahierers gelieferten Signals durch eine Konstante gleich ($\nu_1$-$\nu_2$) zu teilen und am Eingang des Filters (50) das so geteilte Signal zu liefern, wobei die Konstanten $\nu_1$ und $\nu_2$ gleich den Amplituden der Träger auf der Frequenz $f_c$ in den am Eingang der ersten bzw. zweiten Multiplizierer gelieferten Signale sind.

**3.** Empfänger für den Empfang eines modulierten Signals, das eine durch einen Träger auf eine in einem Hochfrequenzband enthaltene vorbestimmte Frequenz $f_c$ modulierte Hüllkurve aufweist, wobei die Hüllkurve eine zu einem Nutzsignal $s_{fi}(t)$ addierte Konstante $\nu_1$ aufweist, wobei der wesentliche Teil der Leistung des Nutzsignals $s_{fi}(t)$ innerhalb eines nutzbaren Frequenzbands enthalten ist, das auf eine Zwischenfrequenz $f_i$ zentriert ist und eine Breite $L_u$ hat, wobei dieser Empfänger aufweist:

- einen Eingangspunkt (30) des im Hochfrequenzband empfangenen modulierten Signals,
- ein an den Eingangspunkt (30) angeschlossenes Tiefpassfilter (32), wobei dieses Tiefpassfilter geeignet ist:

• das Rauschen zu dämpfen, das sich im empfangenen modulierten Signal außerhalb des Nutzbands und der Frequenz $f_c$ befindet, und
• an einem Ausgang ein gefiltertes Signal zu liefern,

**dadurch gekennzeichnet, dass** der Empfänger eine Hüllkurvenerfassungsschaltung (34) aufweist, die einen Eingangsport ($P_{e34}$), der an den Ausgang des Tiefpassfilters (32) angeschlossen ist, und einen Ausgangsport ($P_{s34}$) aufweist, an dem die erfasste Hüllkurve geliefert wird, wobei diese Hüllkurvenerfassungsschaltung (34) Anspruch 1 entspricht.

**4.** Empfänger nach Anspruch 3, wobei der Empfänger aufweist:

- eine Isolierschaltung (36) von Unterträgern, die an den Ausgangsport der Hüllkurvenerfassungsschaltung (34) angeschlossen ist, wobei diese Unterträger-Isolierschaltung (36) geeignet ist, verschiedene Signale voneinander zu trennen, die gleichzeitig mittels verschiedener Unterträger übertragen werden, die sich alle innerhalb des nutzbaren Frequenzbands befinden, und
- Demodulatoren (D$_i$), die an jeweilige Ausgange der Isolierschaltung angeschlossen und je geeignet sind, das isolierte Signal auf einem Unterträger zu demodulieren.

**5.** Empfänger nach Anspruch 3 oder 4, wobei der Eingangspunkt (30) eine Antenne ist, die geeignet ist, das modulierte Signal mittels einer drahtlosen Verbindung zu empfangen.

**6.** Hüllkurvenerfassungsverfahren für ein in einem Hochfrequenzband, d.h. einem Frequenzband oberhalb von 30 GHz, moduliertes Signal, wobei dieses Verfahren aufweist:

- den Empfang (100) des im Hochfrequenzband modulierten Signals an einem Eingangsport, wobei dieses modulierte Signal eine von einem Träger auf eine im Hochfrequenzband enthaltene vorbestimmte Frequenz f$_c$ modulierte Hüllkurve aufweist, wobei die Hüllkurve eine zu einem Nutzsignal s$_{fi}$(t) addierte Konstante $\nu_1$ aufweist, wobei der wesentliche Teil der Leistung des Nutzsignals s$_{fi}$(t) innerhalb eines nutzbaren Frequenzbands liegt, das auf eine Zwischenfrequenz f$^i$ zentriert ist und einer Breite L$_u$ hat,
- die Multiplikation (104) eines ersten Exemplars des am Eingangsport empfangenen Signals mit sich selbst,
- parallel die Modifikation (106) eines zweiten Exemplars des am Eingangsport empfangenen Signals, um ein modifiziertes Signal zu erhalten, wobei die Amplitude des Trägers bei der Frequenz f$_c$ modifiziert wird, während die Amplitude des Nutzsignals unverändert gelassen wird, dann
- die Multiplikation (108) des modifizierten Signals mit sich selbst,
- die Subtraktion (110) des mit sich selbst multiplizierten modifizierten Signals vom ersten Exemplar des mit sich selbst multiplizierten empfangenen Signals, um ein Signal d$_{fi}$(t) zu erhalten,
- das Filtern (114) der Frequenzkomponenten höher als oder gleich 2f$_c$ im Signal dfi(t) mit Hilfe eines Filters, das zu diesem Zweck eine Grenzfrequenz bei -3dB zwischen f$_i$+L$_u$/2 und 2f$_c$ aufweist, und das Liefern des Ergebnisses dieser Filterung als die erfasste Hüllkurve für das modulierte Signal an einem Ausgangsport (P$_{s34}$).

## Claims

**1.** Circuit for detecting the envelope of a signal modulated in a high-frequency band, i.e. in a frequency band located above 30 GHz, this circuit comprising:

- an input port (P$_{e34}$) able to receive the signal modulated in the high-frequency band, this modulated signal comprising an envelope modulated by a carrier at a preset frequency f$_c$ comprised in the high-frequency band, the envelope comprising a constant $\nu_1$ added to a useful signal s$_{fi}$(t), most of the power of the useful signal sfi(t) being comprised inside a useful frequency band centred on an intermediate frequency f$_i$ and of width L$_u$,
- an output port (P$_{s34}$) via which the detected envelope of the modulated signal is delivered,
- a first multiplier (40) connected to the input port and able:

• to multiply a first example of the signal received on the input port by itself, and
• to deliver on an output this first example of the received signal multiplied by itself,

- a modifier (42) connected, in parallel to the first multiplier, to the input port, this modifier being able:

• to modify the amplitude of the power spectrum, of a second example of the signal received on the input port, at the frequency f$_c$ without modifying the amplitude of this power spectrum in the useful frequency band, and
• to deliver on an output the modified signal,

- a second multiplier (44) connected to the output of the modifier and able:

• to multiply the modified signal by itself, and
• to deliver on an output the modified signal multiplied by itself,

- a subtractor (46) comprising first and second inputs connected to the outputs of the first and second multipliers, respectively, this subtractor being able:

• to subtract the signal received on its first input from the signal received on its second input, and
• to deliver on an output the result of this subtraction,

- a filter (50) able to remove frequency components higher than or equal to $2f_c$ in a signal obtained from the signal delivered by the output of the subtractor, this filter comprising to this end a -3 dB cut-off frequency comprised between $f_i + L_u/2$ and $2f_c$, this filter being able to deliver the result of this filtering, by way of detected envelope of the modulated signal, on an output connected to the output port of the envelope-detecting circuit.

**2.** Circuit according to Claim 1, wherein the circuit comprises an amplitude divider (48) connected between the output of the subtractor (46) and an input of the filter (50), this divider being able to divide the amplitude of the signal delivered on the output of the subtractor by a constant equal to $(v_1 - v_2)$ and to deliver on the input of the filter (50) the signal thus divided, the constants $v_1$ and $v_2$ being equal to the amplitudes of the carriers at the frequency $f_c$ in the signals delivered as input to the first and second multipliers, respectively.

**3.** Receiver for receiving a modulated signal comprising an envelope modulated by a carrier at a preset frequency $f_c$ comprised in a high-frequency band, the envelope comprising a constant $v_1$ added to a useful signal sfi(t), most of the power of the useful signal sfi(t) being comprised inside a useful frequency band centred on a preset intermediate frequency $f_i$ and of width $L_u$, this receiver comprising:

- a point (30) of input of the received signal modulated in the high-frequency band,
- a bandpass filter (32) connected to the point (30) of input, this bandpass filter being able:

• to attenuate noise found, in the received modulated signal, outside of the useful band and of the frequency $f_c$, and
• to deliver on an output a filtered signal,

**characterized in that** the receiver comprises an envelope-detecting circuit (34) comprising an input port ($P_{e34}$) connected to the output of the bandpass filter (32) and an output port ($P_{s34}$) on which is delivered the detected envelope, this envelope-detecting circuit (34) being according to Claim 1.

**4.** Receiver according to Claim 3, wherein the receiver comprises:

- a circuit (36) for isolating sub-carriers, this circuit (36) for isolating sub-carriers being connected to the output port of the envelope-detecting circuit (34) and being able to separate from one another various signals transmitted simultaneously via various sub-carriers all located inside the useful frequency band, and
- demodulators ($D_i$) connected to respective outputs of the isolating circuit and each able to demodulate the signal isolated on one sub-carrier.

**5.** Receiver according to Claim 3 or 4, wherein the point (30) of input is an antenna able to receive the modulated signal via a wireless link.

**6.** Method for detecting the envelope of a signal modulated in a high-frequency band, i.e. in a frequency band located above 30 GHz, this method comprising:

- receiving (100) on an input port the signal modulated in the high-frequency band, this modulated signal comprising an envelope modulated by a carrier at a preset frequency $f_c$ comprised in the high-frequency band, the envelope comprising a constant $v_1$ added to a useful signal $s_{fi}(t)$, most of the power of the useful signal sfi(t) being comprised inside a useful frequency band centred on an intermediate frequency $f_i$ and of width $L_u$,
- multiplying (104) a first example of the signal received on the input port by itself,
- in parallel, modifying (106) a second example of the signal received on the input port so as to obtain a modified signal in which the amplitude of the carrier at the frequency $f_c$ is modified while the amplitude of the useful signal is left unchanged, then
- multiplying (108) the modified signal by itself,
- subtracting (110) the modified signal multiplied by itself from the first example of the received signal multiplied by itself to obtain a signal $d_{fi}(t)$,
- filtering (114) frequency components higher than or equal to $2f_c$ in the signal dfi(t) using a filter comprising to this end a - 3 dB cut-off frequency comprised between $f_i + L_u/2$ and $2f_c$ and delivering the result of this filtering, by way of detected envelope of the modulated signal, on an output port ($P_{s34}$).

Fig. 1

Fig. 2

Fig. 3

60

62

64

66

68

70

72

74

80

82

84

86

88

90

92

Fig. 4

100

102

104

106

108

110

112

114

116

Fig. 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 3508155 A

**Littérature non-brevet citée dans la description**

- **H. VOELCKER.** Demodulation of single-sideband signais via envelope détection. *IEEE Transactions on Communications Technology,* Février 1966, vol. 14 (1
- **ANTONIO MECOZZI et al.** Kramers-Kronig coherent receiver. *OPTICA,* 20 Novembre 2016, vol. 3 (11), 1220-1227
- **M.A.M.A ZAID et al.** Eveloppe détection and correction of SSB. *Electronics letters,* 01 Janvier 1984, vol. 20 (22), 901
- **JOHN G. PROAKIS.** Digital Communication
- **M. SRINIVASAN.** Comparision of prime codes, extended prime codes and quadratic congruence code using normalized throughput metric. *Transparent Optical Networks, 2004. Proceedings of 2004 6th International Conférence on,* 04 Juillet 2004, vol. 2, 168-171